(19) **Europäisches Patentamt / European Patent Office / Office européen des brevets**

(11) **EP 2 588 823 B1**

(12) **FASCICULE DE BREVET EUROPEEN**

(45) Date de publication et mention de la délivrance du brevet:
**18.05.2016 Bulletin 2016/20**

(21) Numéro de dépôt: **11730931.0**

(22) Date de dépôt: **27.06.2011**

(51) Int Cl.:
*F26B 5/04* (2006.01)          *F26B 7/00* (2006.01)
*F26B 21/14* (2006.01)          *G03F 1/82* (2012.01)

(86) Numéro de dépôt international:
**PCT/EP2011/060750**

(87) Numéro de publication internationale:
**WO 2012/000951 (05.01.2012 Gazette 2012/01)**

(54) **DISPOSITIF ET PROCÉDÉ DE SÉCHAGE D'UN PHOTOMASQUE**

VORRICHTUNG UND VERFAHREN ZUM TROCKNEN EINER FOTOMASKE

DEVICE AND METHOD FOR DRYING A PHOTOMASK

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **30.06.2010 FR 1002765**

(43) Date de publication de la demande:
**08.05.2013 Bulletin 2013/19**

(73) Titulaire: **Pfeiffer Vacuum
74000 Annecy (FR)**

(72) Inventeurs:
- **THOVEX, Cindy
  74220 La Clusaz (FR)**
- **BELLET, Bertrand
  F-73000 Chambery (FR)**

(74) Mandataire: **Croonenbroek, Thomas Jakob
Innovincia
11, avenue des Tilleuls
74200 Thonon-les-Bains (FR)**

(56) Documents cités:
**EP-A1- 1 925 909          EP-A2- 1 832 353
WO-A1-2009/112655          US-A1- 2007 187 272**

EP 2 588 823 B1

**Description**

La présente invention se rapporte à un dispositif de séchage d'un photomasque, notamment employé dans la fabrication de composants microélectroniques aux dimensions submicroniques. Elle s'étend en outre au procédé de séchage du photomasque.

Le micro-usinage des substrats semiconducteurs, notamment en silicium, est actuellement réalisé par des techniques de gravure au plasma d'un motif transféré sur le substrat à partir d'un photomasque par un procédé de lithographie. Un photomasque est équivalent à un négatif en photographie : il contient une information à imprimer sur un support. Les pollutions dans la zone active du photomasque ont un effet direct sur l'image imprimée sur le substrat avec l'impression d'un défaut.

Par ailleurs, l'industrie du semi-conducteur cherche à réduire la dimension de l'image inscrite afin d'obtenir des composants électroniques toujours plus petits, intégrables et moins coûteux. Les dimensions d'un photomasque se réduisant, les exigences en matière de pollution deviennent de plus en plus strictes. Pour permettre la gravure de motifs de dimensions inférieures à 100nm, la longueur d'onde du laser de lithographie est passée de 193nm dans la technique classique à 13,5nm dans la technique plus récente dite technique EUV (pour Extrême Ultra-Violet). Le photomasque est donc un élément clef, cher et complexe que l'on cherche à conserver propre et opérationnel.

A la fin de sa fabrication, le photomasque est nettoyé. Dans le cas d'un photomasque utilisé dans la technique classique, une pellicule est alors appliquée sur le photomasque afin de protéger sa face active d'éventuelles particules. La dernière étape de nettoyage est réalisée en milieu humide. Suite à l'étape de nettoyage, le photomasque doit être soigneusement séché afin d'éliminer tout résidu d'humidité adsorbée. Aujourd'hui, c'est en chauffant à très haute température (de l'ordre de 80-90°C) que l'humidité est habituellement éliminée. Il s'agit d'un mode de séchage agissant essentiellement en surface

WO2009/112655 divulgue un dispositif de séchage d'un photomasque comprenant : une enceinte étanche contenant au moins un photomasque, un groupe de pompage pour installer et maintenir le vide à l'intérieur de ladite l'enceinte, un support du photomasque, placé à l'intérieur de ladite enceinte, des moyens de rayonnement infrarouge placés à l'intérieur de ladite enceinte, un système d'injection de gaz dans ladite enceinte, les moyens de rayonnement infrarouge comprenant une pluralité de sources de rayonnement infrarouge réparties dans un plan parallèle au plan du photomasque, le système d'injection de gaz comprenant une pluralité d'injecteurs de gaz répartis dans un plan parallèle au plan du photomasque, et le dispositif de séchage comprenant au moins trois sources de rayonnement infrarouge alignées de manière que deux sources de rayonnement infrarouge soient placées respectivement de part et d'autre du photomasque.

Un photomasque EUV, destiné à être utilisé dans la technique EUV, ne porte pas de pellicule. C'est un élément plat formé d'un empilement de type « millefeuilles » composé de très fines couches de différents matériaux (MoSi, TaN...) déposées sur une base de quartz. Il ne peut pas être exposé à une température supérieure à 60°C, ni à un écart de température de plus de 10°C sur sa surface active, car une température ou un gradient de température trop élevé conduirait à une dilation trop importante de certaines couches, et le photomasque EUV en serait détérioré.

L'efficacité du séchage est généralement évaluée par la mesure de l'angle de contact θ d'une goutte de liquide sur la surface du photomasque. Lorsqu'une goutte est déposée sur une surface solide, elle s'étale jusqu'à atteindre l'équilibre des forces entre les différentes phases en présence (solide, liquide et vapeur). La relation entre ces différentes forces et l'angle de contact est donnée par l'équation de Young :

$$\gamma_{SV} = \gamma_{LV} \cos \theta + \gamma_{SL}$$

dans laquelle : $\gamma_{SV}$ est la tension interfaciale solide-vapeur,
$\gamma_{LV}$ est la tension interfaciale liquide-vapeur,
$\gamma_{SL}$ est la tension interfaciale solide-liquide, et
θ est la valeur de l'angle de contact entre une goutte de liquide et la surface du photomasque.

Le caractère hydrophile ou hydrophobe de la surface d'un photomasque dépend du matériau qui la constitue, et il est mesuré par l'angle de contact θ. Une fois bien sèche, la surface du photomasque est hydrophobe, la goutte s'étale peu et l'angle de contact est important. Pour que la surface d'un photomasque soit considérée comme étant suffisamment hydrophobe, l'angle de contact θ doit être supérieur à 55° pour le chrome, 25° pour le quartz, 60° pour le ruthénium et 70° pour le nitrure de tantale. Or les méthodes par chauffage, telle qu'elles sont aujourd'hui utilisées, ne permettent pas d'atteindre cette efficacité en restant à des températures modérées.

Le besoin se fait donc sentir d'un procédé de séchage qui respecte à la fois les contraintes liées au photomasque EUV lui-même, mais aussi les contraintes liées à l'équipement déjà existant et aux conditions de fabrication. Néanmoins le séchage obtenu par ce procédé doit être aussi efficace, voire plus efficace, que les procédés connus. L'étape de séchage doit permettre un séchage volumique et homogène du photomasque EUV sans entraîner sa dégradation, notamment à cause de la température, et sans perturber la fabrication. Ainsi il faut sécher le photomasque EUV dans un temps maximum de 20 minutes, ce qui correspond au temps disponible dans le flux de fabrication. A la fin de l'étape de séchage, le photomasque EUV doit être à une température de l'ordre de 30°C à 35°C.

La présente invention a aussi pour but de proposer un dispositif de séchage d'un photomasque EUV, destiné à être utilisé dans la technique EUV, exempt de pellicule, et pour lequel la température de séchage ne doit pas dépasser 60°C.

L'invention a encore pour but de proposer un dispositif permettant d'assurer l'homogénéité de la température sur toute la surface du photomasque EUV. En effet la température doit être contrôlée avec une grande précision car la température à la surface du photomasque EUV doit être maintenue constante et uniforme avec une variation maximum de $\pm 5$°C pendant toute la durée de l'étape de séchage.

L'objet de la présente invention est un dispositif de séchage d'un photomasque selon la revendication 1.

De préférence les sources de rayonnement infrarouge sont placées de manière à envoyer le rayonnement infrarouge perpendiculairement à la surface active du photomasque.

Selon l'invention, le dispositif de séchage comprend au moins trois sources de rayonnement infrarouge alignées de manière à ce que deux sources de rayonnement IR soit placées respectivement de part et d'autre du photomasque et qu'une source de rayonnement infrarouge au moins soit placée au centre du photomasque.

Le diamètre de l'orifice d'injection de gaz disposé en vis-à-vis du centre du photomasque est plus important que le diamètre des autres orifices.

Selon un deuxième mode de réalisation, le dispositif de séchage comprend des moyens de mesure de la température munis de pyromètres, disposés de manière à mesurer la température sur la tranche du photomasque.

Selon un troisième mode de réalisation, le dispositif de séchage comprend un support du photomasque comportant des moyens de réception et de positionnement du photomasque, comprenant un cadre percé suspendu à l'intérieur de l'enceinte étanche.

Selon un quatrième mode de réalisation, le dispositif comprend des capteurs de distance à ultrasons.

Selon un cinquième mode de réalisation, le dispositif de séchage comprend des moyens de mesure de la pression, de la température et de la distance et un dispositif de contrôle et de commande apte à recevoir des informations des moyens de mesure de la pression, de la température et de la distance et apte à piloter les moyens de rayonnement infrarouge et le système d'injection de gaz en fonction des informations reçues.

L'invention a encore comme objet un procédé de séchage d'un photomasque au moyen du dispositif de séchage précédent, comprenant les étapes suivantes :

- on positionne le photomasque dans une enceinte étanche à pression atmosphérique,
- on chauffe le photomasque jusqu'à une température fixée au plus égale à 60°C,
- on établit une basse pression dans l'enceinte étanche en pompant les gaz qu'elle contient,
- on maintient l'enceinte à basse pression et à la température fixée pendant une durée fixée,
- on arrête le chauffage du photomasque,
- on rétablit la pression atmosphérique dans l'enceinte par injection d'un gaz neutre, et
- on vérifie que la température du photomasque est d'environ 30-35°C avant d'extraire le photomasque de l'enceinte.

Selon une variante, on vérifie le positionnement du photomasque au moyen d'au moins trois capteurs de distance à ultrasons.

Bien entendu le dispositif et le procédé de séchage selon l'invention peuvent aussi être utilisés pour sécher, avant application de la pellicule, des photomasques utilisés dans les techniques classiques.

D'autres caractéristiques et avantages de la présente invention apparaîtront à la lecture de la description qui suit d'un mode de réalisation, donné bien entendu à titre illustratif et non limitatif, et dans le dessin annexé sur lequel

- la figure 1 montre schématiquement les différents moyens que comprend le dispositif de séchage d'un photomasque EUV,
- la figure 2 est une vue de dessous schématique montrant la position des sources de rayonnement infrarouge par rapport au photomasque EUV,
- la figure 3 montre la position spatiale du rayonnement émis par les sources de rayonnement infrarouge et le rayonnement résultant reçu par le photomasque EUV, le rayonnement R en W/mm$^2$ est donné en ordonnée et l'éloignement L en millimètres du centre du photomasque EUV est porté en abscisse,
- la figure 4 représente une vue de la distribution de température sur la surface d'un photomasque après que le photomasque ait reçu le rayonnement résultant des sources de rayonnement infrarouge,
- la figure 5 est une vue de dessus schématique montrant la position des injecteurs de gaz par rapport au photomasque EUV,
- la figure 6 représente une vue en perspective de la circulation du gaz injecté par le système d'injection de gaz,
- la figure 7 représente un mode de réalisation d'un moyen de réception et de positionnement du photomasque EUV, et
- la figure 8 montre l'évolution de la valeur de l'angle de contact d'une goutte de liquide sur la surface du photomasque EUV au fur et à mesure de l'avancement de son nettoyage, l'angle de contact $\theta$ est donné en ordonnée et le déroulement des opérations de nettoyage est porté en abscisse.

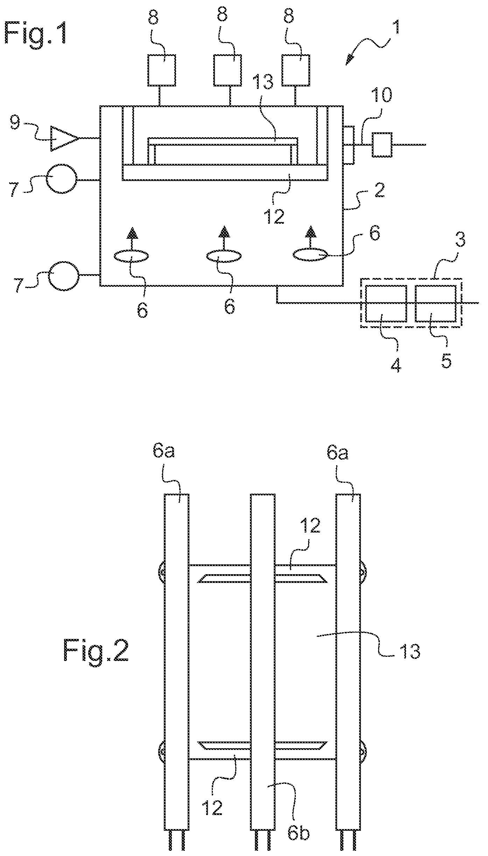

Le dispositif **1** utilisé pour le séchage d'un photomasque EUV est représenté schématiquement sur la figure 1. Le dispositif **1** est destiné à être intégré dans un équipement de nettoyage de photomasques.

Le dispositif **1** comprend une enceinte **2** étanche apte à recevoir un photomasque EUV, une unité de pompage **3** comprenant par exemple une pompe primaire **5** et une pompe secondaire **4**, des moyens de rayonnement infrarouge comprenant une pluralité de sources de rayonnement infrarouge **6** placées dans la partie inférieure de l'enceinte **2**, des capteurs de pression **7**, des capteurs de distance à ultrasons **8** placés dans la partie supérieure de l'enceinte **2**, au moins un pyromètre **9**, un système d'injection de gaz comprenant une ligne d'injection de gaz **10**, une soupape de surpression permettant d'éviter une montée en pression dans l'enceinte **2**, et un support de photomasque **12**.

Le contrôle de la température du photomasque EUV au cours de l'étape de séchage est effectué au moyen d'au moins un pyromètre **9** visant la tranche du photomasque **13**, de préférence au plus près du centre. Pour la mise au point du système de contrôle et pour la vérification périodique du pyromètre, une courbe de calibration est réalisée sur la gamme complète des températures. La température moyenne du photomasque EUV est calculée à partir des données fournies par une pluralité de capteurs de température, de préférence au moins neuf, mesurant la température en différents points de la surface du photomasque EUV.

Des capteurs de distance à ultrasons **8**, de préférence au nombre de trois, sont disposés dans la partie supérieure de l'enceinte. Les capteurs de distance à ultrasons **8** mesurent la distance les séparant du photomasque **13** en plusieurs points de sa surface. Les capteurs de distance à ultrasons **8** permettent de détecter si un photomasque EUV a été introduit dans l'enceinte **2**, de déterminer sa taille et de valider son bon positionnement dans l'enceinte **2**, notamment en ce qui concerne l'horizontalité, ou assiette, du photomasque EUV.

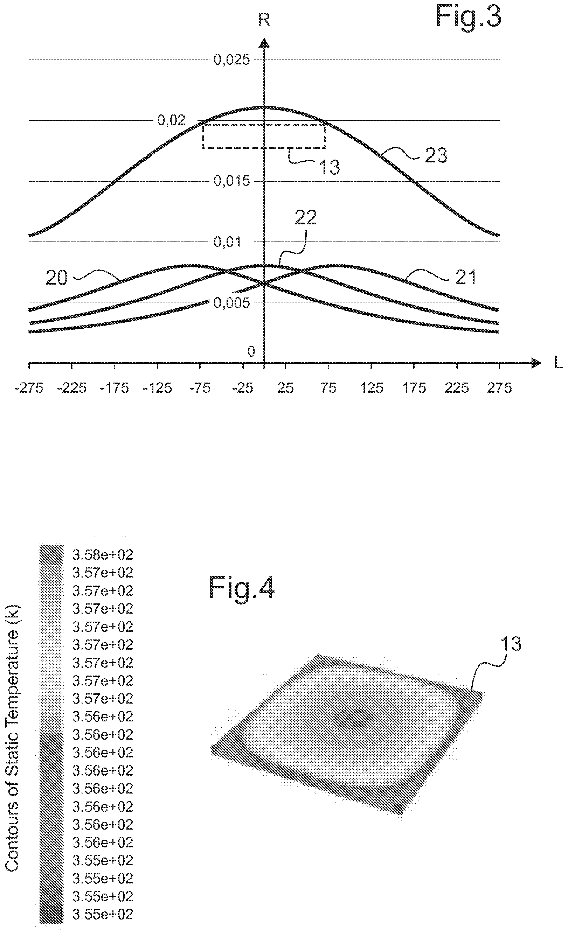

Des sources de rayonnement infrarouge **6**, comme des lampes à infrarouge, permettent le séchage des photomasques EUV. On choisit par exemple des sources de rayonnement infrarouge 6 identiques et dont le nombre, l'écartement et la distance au photomasque **13** a été choisi de telle sorte que le chauffage soit sensiblement uniforme sur la surface du photomasque **13** comme montré sur les figures 2 et 3.

Les sources de rayonnement infrarouge **6** sont placées dans la partie inférieure de l'enceinte **2** du côté de la face active du photomasque EUV **13**, dans un plan parallèle à la surface du photomasque EUV **13**, de manière à envoyer le rayonnement infrarouge perpendiculairement directement sur la face active des photomasques EUV **13**. Les sources de rayonnement infrarouge **6** sont au moins trois. Deux d'entre elles **6a** sont positionnées vers les extrémités de l'enceinte, de manière à être placées de part et d'autre du photomasque **13**. La ou les autres sources de rayonnement infrarouge **6b** sont disposées au centre de l'enceinte, de manière à correspondre sensiblement au centre du photomasque **13**. Dans cet exemple, les trois sources de rayonnement infrarouge **6** sont éloignées l'une de l'autre d'une distance **d** qui vaut 83 mm. Les sources de rayonnement **6a**, **6b** sont disposées dans un plan distant de la surface du photomasque **13** d'une distance **D** qui vaut ici : D = 1,5 X d, soit 125 mm.

Ce positionnement permet d'avoir un recoupement des spectres radiants de chaque lampe infrarouge **6** favorisant ainsi un chauffage uniforme sur toute la surface du photomasque **13**. La figure 3 montre la valeur du rayonnement **R** en W/mm$^2$ en fonction de l'éloignement **L** en millimètres du centre du photomasque **13**. Les sources de rayonnement infrarouge placées de part et d'autre du photomasque émettent un rayonnement **20** et **21** respectivement, et la source de rayonnement infrarouge disposée entre elles, au centre, émet un rayonnement **22**. L'addition de ces rayonnements **20, 21** et **22** a pour résultante un rayonnement **23**. On a représenté la position d'un photomasque **13** (en pointillé), dont le côté mesure 2L = 150mm, recevant le rayonnement résultant **23**. Le centre du photomasque **13** se trouve au point L = 0 et le photomasque **13** occupe donc la position comprise entre L = -75 et L = +75. On constate que la surface du photomasque **13** reçoit ainsi un rayonnement **23** dont l'uniformité est sensiblement améliorée, par exemple par rapport au rayonnement reçu de la seule source **6** placée au centre. La figure 4 illustre un exemple de distribution de la température obtenue à la surface du photomasque 13. Du fait de la configuration sensiblement plate du photomasque, le gradient de température dans la tranche du photomasque 13 est négligeable. On voit sur cet exemple que la répartition de température présente une forme sensiblement en cloche avec au centre du photomasque, une zone sensiblement plus chaude que les zones périphériques, elles-mêmes sensiblement plus chaudes que les zones au bord du photomasque 13. Cependant, la disposition des sources de rayonnement infrarouge 6 par rapport au photomasque 13 permet d'obtenir un gradient de température en surface du photomasque acceptable, c'est-à-dire inférieur à 10°C sur la surface active du photomasque **13**.

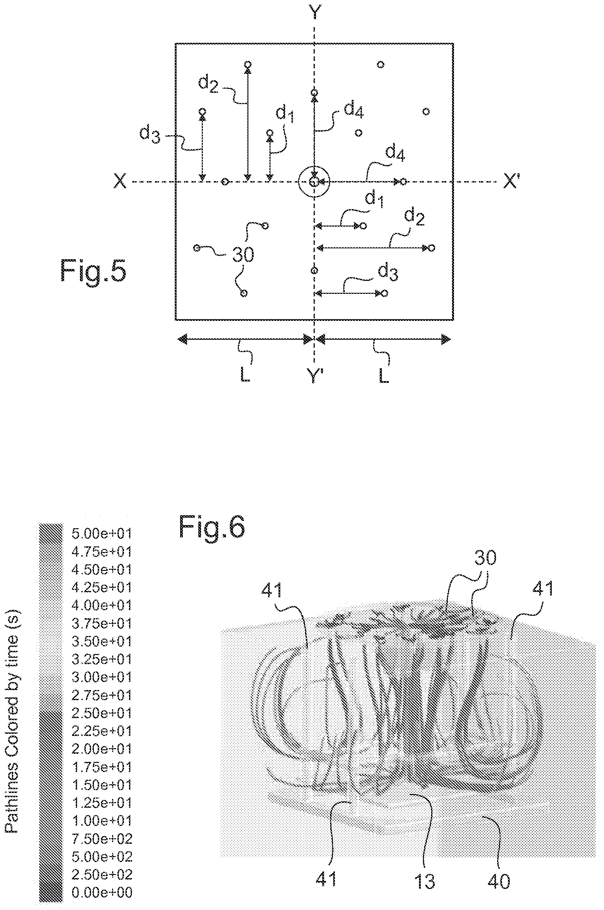

En chauffant le photomasque par les moyens de rayonnement infrarouge et en le soumettant à une pression inférieure à la pression atmosphérique par l'unité de pompage **3**, par exemple à une pression de l'ordre de 10$^{-5}$ mbar, on favorise la diffusion des gaz présents dans le matériau vers la surface et ainsi leur dégazage sous vide. L'étape de séchage permet donc un séchage volumique et homogène sans dégradation du photomasque. Les figures 5 et 6 représentent un mode de réalisation du système d'injection de gaz **10** comportant une pluralité d'injecteurs **30** de gaz, par exemple de l'azote ou de l'hélium, placés dans la partie supérieure de l'enceinte **2** de manière à envoyer un flux de gaz sur la face opposée à la face active du photomasque **13**. Le système d'injection **10** de gaz comprend une pluralité d'injecteurs **30** de gaz répartis dans un plan parallèle au plan du photomasque **13** de telle sorte que les injecteurs **30** respectent une invariance par rotation de 90° autour d'un point coïncidant avec un point en vis-à-vis du centre du photomasque **13**. Le photomasque **13** est un carré dont le côté mesure 2L = 150mm. Les injecteurs **30** sont placés à une distance $d_1$, $d_2$, et $d_3$ respectivement des axes perpendiculaires **X-X'** et **Y-Y'**, passant par le centre du photomasque **13** et le milieu de ses côtés et à une distance $d_4$ sur ces axes **X-X'** et **Y-Y'**. Dans le cas présent ces distances valent par exemple : $d_1$ = 25 mm, $d_2$ = 62,5 mm, $d_3$ = 37,5 mm et $d_4$ = 50 mm. La projection de ces distances $d_1$, $d_2$, $d_3$ et $d_4$ sur les axes **X-X'** et **Y-Y'** sont équidistantes.

Une fois les moyens de rayonnement infrarouge arrêtés et l'unité de pompage **3** isolée de l'enceinte **2**, le photomasque **13** se refroidit par échange radiatif et convectif entre ses surfaces externes et son environnement. On envoie alors du gaz par les injecteurs de gaz 30, ce qui permet d'accélérer le refroidissement par convection forcée comme on peut le voir sur la figure 6 représentant la circulation du gaz injecté. Toutefois, l'agencement particulier des injecteurs **30** de gaz permet de refroidir la surface du photomasque 13 en fonction de la répartition de température résultant de la disposition des sources de rayonnement infrarouge. On constate qu'avec cette répartition des injecteurs 30, le gaz utilisé (hélium ou azote) s'oriente d'abord vers le centre du photomasque 13, puis s'étend symétriquement sur la surface du photomasque en remontant ensuite le long des parois de l'enceinte. La disposition des injecteurs 30 dans l'enceinte vis-à-vis du photomasque est donc complémentaire à la disposition des sources de rayonnement infrarouge pour compenser la répartition de température « en cloche », c'est-à-dire en refroidissant plus fortement le centre du photomasque. Ainsi, l'injection de gaz n'accentue pas le gradient de température présent à la surface du photomasque mais permet de le conserver au-dessous de 10°C sur la surface active du photomasque.

Pour accentuer encore le refroidissement au centre du photomasque, on prévoit en plus que le diamètre de l'orifice d'injection de gaz disposé en vis-à-vis du centre du photomasque soit plus important que le diamètre des autres orifices d'injection. Par exemple, le diamètre de l'orifice d'injection de gaz disposé en vis-à-vis du centre du photomasque est de l'ordre du double du diamètre des autres orifices d'injection. On dispose ainsi par exemple dix-sept injecteurs de gaz 30 pour trois sources de rayonnement infrarouge 6.

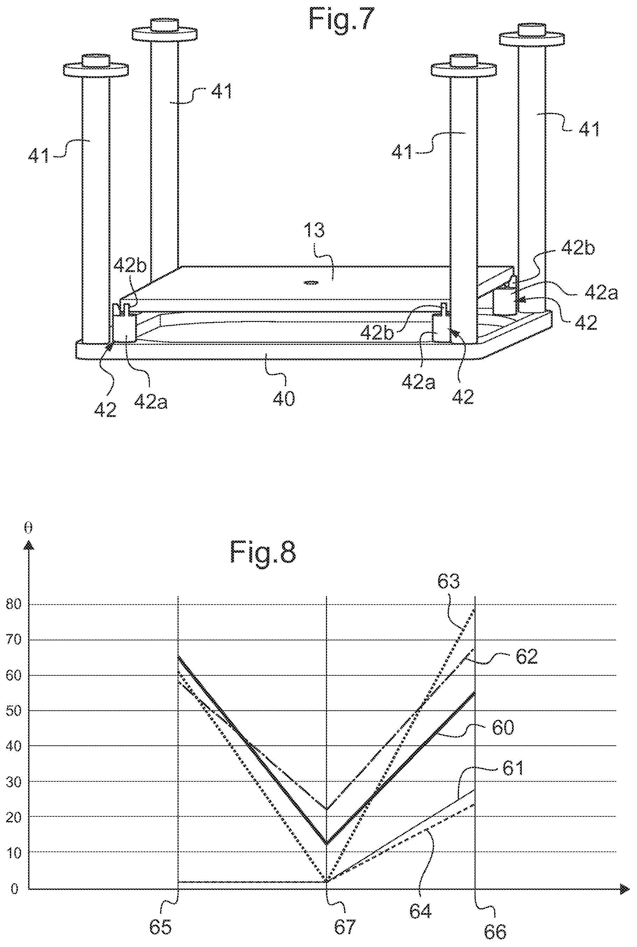

Un mode de réalisation du support 12 du photomasque du dispositif de séchage comportant des moyens de réception et de positionnement du photomasque permettant de recevoir et de positionner un photomasque 13 est représenté sur les figures 6 et 7. Ces moyens comportent un cadre 40 percé, de taille adaptée à la taille du photomasque 13 qu'il doit recevoir, suspendu à l'intérieur de l'enceinte 2 par quatre colonnes 41. Les sources de rayonnement infrarouge 6 peuvent ainsi rayonner vers la face active du photomasque EUV 13 sans obstacle au rayonnement à travers le cadre 40. En outre, le moyen permettant de recevoir et de positionner le photomasque en forme de cadre percé favorise le refroidissement du photomasque par échange radiatif et convectif et limite les transferts de chaleur par conduction, de manière à maîtriser l'homogénéité du refroidissement.

Les colonnes 41 sont fixées d'une part à la partie supérieure de l'enceinte 2 et d'autre part aux quatre coins du cadre 40. Quatre plots 42 portés par le cadre 40 ont pour fonction de réceptionner et de positionner correctement le photomasque **13**. Ces plots **42** sont constitués de deux parties : une première partie **42a,** par exemple en acier inoxydable ou en céramique, permettant le raccordement au cadre **40** et une seconde partie **42b** constituée de deux doigts de réception, par exemple en or, sur lequel va reposer le photomasque **13**. Dans le cas où la partie **42a** de raccordement est en céramique, les doigts **42b** sont raccordés à la masse de l'enceinte **2** afin de permettre au photomasque **13** de décharger son électricité statique car au cours du séchage le photomasque **13** se charge électrostatiquement.

Si nécessaire, le dispositif de séchage peut comporter plusieurs supports, chacun muni d'un cadre percé de taille différente, disposés de telle sorte que le support ayant le cadre de plus petite dimension soit placé au-dessus.

En outre un dispositif de contrôle et de commande reçoit des informations des moyens de mesure de la pression, de la température et de la distance, et en déduit des instructions pour piloter les moyens de rayonnement infrarouge et le système d'injection de gaz en fonction des informations reçues. Le dispositif de contrôle et de commande est aussi apte à communiquer avec l'équipement de nettoyage des photomasques et avec le robot de transfert entre l'équipement de nettoyage et le dispositif de séchage d'un photomasque.

Le procédé de nettoyage comporte une étape de séchage comprenant les opérations suivantes. Le photomasque **13** est transporté depuis l'équipement de nettoyage jusqu'à l'enceinte **2** du dispositif de séchage **1** par un robot qui vient déposer le photomasque **13** sur le cadre **40** percé. La vanne de transfert se referme.

Une vérification du positionnement du photomasque **13** est réalisée à l'aide des capteurs de distance à ultrasons **8**, ici trois capteurs par exemple. Si les mesures données par les capteurs à ultrasons **8** sont identiques, le bon positionnement horizontal du photomasque est validé. La valeur mesurée est alors mémorisée dans le dispositif de contrôle et de commande.

Le chauffage débute à pression atmosphérique. L'évolution de la température est mesurée en temps réel au moyen du pyromètre **9**. L'uniformité du chauffage des photomasques est assurée grâce à un chauffage intermittent qui alterne les périodes d'allumage des sources de rayonnement infrarouge **6**, par exemple de 1 s, et les périodes d'extinction, par exemple de 2s. Dès que le photomasque **13** atteint une température fixée, inférieure ou égale à 60°C, l'unité de pompage **3** est mise en route pour réaliser le pompage de l'enceinte **2**. L'utilisation d'une pompe primaire **5** et d'une pompe secondaire **4** montées en série permet de pousser le vide jusqu'à 10⁻⁵ mbar. Le vide secondaire ainsi atteint permet une désorption plus efficace du photomasque **13**. Le photomasque **13** est maintenu à une température proche de 60°C pendant environ 10 minutes.

Puis, les moyens de rayonnement infrarouge sont arrêtés et on isole l'unité de pompage 3 de l'enceinte 2. La remontée en pression dans l'enceinte 2 est ensuite réalisée par l'injection d'un flux de gaz neutre, comme par exemple de l'azote. Le système d'injection de gaz se présente de préférence sous la forme d'une pluralité d'injecteurs **30**, disposés comme représenté sur la figure 4 ou bien sous forme de buses, de manière à éviter la génération de particules. Le système d'injection de gaz est disposé au-dessus du photomasque **13** et permet une injection en plusieurs points de manière à assurer une distribution homogène du flux gazeux à la surface du photomasque **13**. Le gaz injecté permet ainsi de refroidir le photomasque 13 et d'assurer la remontée en pression. En outre, la disposition des moyens infrarouge et du système d'injection d'un flux de gaz permettent d'uniformiser la température sur la surface active du photomasque avec un écart de température sur la surface active inférieur à 10°C. Lorsque la pression atteint la pression atmosphérique, l'injection d'azote est remplacée par une injection d'hélium qui est plus efficace du point de vue du refroidissement. Lorsque la température du photomasque **13** atteint environ 30°C à 35°C, le refroidissement est stoppé et le photomasque **13** peut être retiré de l'enceinte **2**. On attend que la température du photomasque 13 atteigne environ 30°C à 35°C avant d'extraire le photomasque 13 de l'enceinte, pour que le photomasque 13 soit à une température voisine de la température ambiante, dans le but d'éviter la ré-adsorption des gaz présents dans l'atmosphère qui pourrait se produire lors de la baisse de température.

La figure 8 permet de se rendre compte de l'efficacité du séchage obtenu par le procédé selon l'invention. Les mesures d'angle de contact θ ont été réalisées sur des surfaces constituées de chrome **60** (Cr), de quartz **61**, de ruthénium **62** (Ru), et de nitrure de tantale **63** (TaN) ou de molybdène silicium **64** (MoSi). On constate que l'angle de contact θ mesuré après l'étape de séchage **66** est du même ordre de grandeur, voire meilleur, que celui mesuré avant l'opération de nettoyage **65** sur tous les matériaux testés. L'angle de contact θ mesuré après l'étape de séchage **66** doit être comparé à la valeur de l'angle de contact θ mesuré avant l'étape de séchage **67**.

## Revendications

**1.** Dispositif de séchage d'un photomasque EUV comprenant :

- une enceinte (2) étanche apte à recevoir au moins un photomasque EUV (13),
- un groupe de pompage (3) pour installer et maintenir le vide à l'intérieur de ladite enceinte (2),
- un support de photomasque (12), placé à l'intérieur de ladite enceinte (2),
- des moyens de rayonnement infrarouge (6) placés à l'intérieur de ladite enceinte (2),
- un système d'injection de gaz (10) dans ladite enceinte (2),

dispositif dans lequel les moyens de rayonnement infrarouge comprennent une pluralité de sources de rayonnement infrarouge (6) réparties dans un plan parallèle au plan de la surface du photomasque EUV (13) de telle sorte que la distance de la surface du photomasque EUV (13) aux moyens de rayonnement IR soit donnée par la relation :

$$D = 1,5 \times d$$

dans laquelle D est la distance entre le plan contenant les sources de rayonnement infrarouge (6) et la surface du photomasque EUV (13), et d est la distance entre les points centraux de deux sources de rayonnement infrarouge voisines (6), le système d'injection de gaz (10) comprenant une pluralité d'injecteurs de gaz (30) répartis dans un plan parallèle au plan du photomasque EUV (13) de telle sorte que les injecteurs (30) respectent une invariance par rotation de 90° autour du point central du photomasque EUV (13), le dispositif de séchage comprenant au moins trois sources de rayonnement infrarouge (6) alignées de manière que deux sources de rayonnement infrarouge (6) soient placées respectivement de part et d'autre du photomasque EUV (13) et qu'une source de rayonnement infrarouge (6) au moins soit placée en vis-à-vis du centre du photomasque EUV (13), le diamètre de l'orifice d'injection de gaz disposé en vis-à-vis du centre du photomasque EUV (13) étant plus important que le diamètre des autres orifices d'injection de gaz.

**2.** Dispositif de séchage selon la revendication 1, dans lequel les sources de rayonnement infrarouge (6) sont placées de manière à envoyer le rayonnement infrarouge perpendiculairement à la surface active du photomasque EUV (13).

**3.** Dispositif de séchage selon l'une des revendications précédentes, comprenant des moyens de mesure de la température (9) munis de pyromètres, disposés de manière à mesurer la température sur la tranche du photomasque EUV (13).

4. Dispositif de séchage selon l'une des revendications précédentes, comprenant un support de photomasque (12) comportant des moyens de réception et de positionnement du photomasque, comprenant un cadre (40) percé suspendu à l'intérieur de ladite enceinte (2).

5. Dispositif de séchage selon l'une des revendications précédentes, comprenant des capteurs de distance à ultrasons (8).

6. Dispositif de séchage selon l'une des revendications précédentes, comprenant des moyens de mesure de la pression (7), de la température (9) et de la distance (8) et un dispositif de contrôle et de commande apte à recevoir des informations des moyens de mesure de la pression (7), de la température (9) et de la distance (8) et apte à piloter les moyens de rayonnement infrarouge (6) et le système d'injection de gaz (10, 30) en fonction des informations reçues.

7. Procédé de séchage d'un photomasque EUV au moyen du dispositif de séchage selon l'une des revendications précédentes, comprenant les étapes suivantes :

    - on positionne le photomasque EUV (13) dans une enceinte (2) étanche à pression atmosphérique,
    - on chauffe le photomasque EUV (13) jusqu'à une température fixée au plus égale à 60°C,
    - on établit une basse pression dans l'enceinte (2) étanche en pompant les gaz qu'elle contient,
    - on maintient l'enceinte (2) à basse pression et à la température fixée pendant une durée fixée,
    - on arrête le chauffage du photomasque EUV (13),
    - on rétablit la pression atmosphérique dans l'enceinte (2) par injection d'un gaz neutre, et
    - on vérifie que la température du photomasque EUV (13) est d'environ 30-35°C avant d'extraire le photomasque EUV (13) de l'enceinte (2).

8. Procédé selon la revendication précédente, dans lequel on vérifie le positionnement du photomasque EUV au moyen d'au moins trois capteurs de distance à ultrasons (8).

**Patentansprüche**

1. Vorrichtung zum Trocknen einer EUV-Fotomaske, die enthält:

    - einen dichten Behälter (2), der mindestens eine EUV-Fotomaske (13) aufnehmen kann,

    - einen Pumpensatz (3), um ein Vakuum im Inneren des Behälters (2) herzustellen und aufrechtzuerhalten,
    - einen Fotomaskenträger (12), der im Inneren des Behälters (2) angeordnet ist,
    - Infrarotstrahlungseinrichtungen (6), die im Inneren des Behälters (2) angeordnet sind,
    - ein System (10) zum Einspritzen von Gas in den Behälter (2),

Vorrichtung, bei der die Infrarotstrahlungseinrichtungen eine Vielzahl von Infrarotstrahlungsquellen (6) enthalten, die in einer Ebene parallel zur Fläche der EUV-Fotomaske (13) so verteilt sind, dass der Abstand der Fläche der EUV-Fotomaske (13) zu den IR-Strahlungseinrichtungen durch die folgende Beziehung gegeben wird:

$$D = 1,5 \times d$$

wobei D der Abstand zwischen der die Infrarotstrahlungsquellen (6) enthaltenden Ebene und der Fläche der EUV-Fotomaske (13) und d der Abstand zwischen den zentralen Punkten von zwei benachbarten Infrarotstrahlungsquellen (6) ist, wobei das eine Vielzahl von Gaseinspritzdüsen (30) enthält, die in einer Ebene parallel zur Ebene der EUV-Fotomaske (13) so verteilt sind, dass die Einspritzdüsen (30) eine 90°-Rotationsinvarianz um den zentralen Punkt der EUV-Fotomaske (13) beachten, wobei die Trocknungsvorrichtung mindestens drei Infrarotstrahlungsquellen (6) enthält, die so ausgerichtet sind, dass zwei Infrarotstrahlungsquellen (6) zu beiden Seiten der EUV-Fotomaske (13) angeordnet sind, und dass mindestens eine Infrarotstrahlungsquelle (6) gegenüber der Mitte der EUV-Fotomaske (13) angeordnet ist, wobei der Durchmesser der gegenüber der Mitte der EUV-Fotomaske (13) angeordneten Gaseinspritzöffnung größer ist als der Durchmesser der anderen Gaseinspritzöffnungen.

2. Trocknungsvorrichtung nach Anspruch 1, wobei die Infrarotstrahlungsquellen (6) so angeordnet sind, dass sie die Infrarotstrahlung senknecht zur aktiven Fläche der EUV-Fotomaske (13) schicken.

3. Trocknungsvorrichtung nach einem der vorhergehenden Ansprüche, die mit Pyrometern versehene Messeinrichtungen der Temperatur (9) enthält, die so angeordnet sind, dass sie die Temperatur auf der Schmalseite der EUV-Fotomaske (13) messen.

4. Trocknungsvorrichtung nach einem der vorhergehenden Ansprüche, die einen Fotomaskenträger (12) enthält, der Einrichtungen zur Aufnahme und Positionierung der Fotomaske aufweist, die einen gelochten Rahmen (40) enthalten, der im Inneren des Behälters (2) aufgehängt ist.

5. Trocknungsvorrichtung nach einem der vorhergehenden Ansprüche, die Ultraschall-Abstandssensoren (8) enthält.

6. Trocknungsvorrichtung nach einem der vorhergehenden Ansprüche, die Messeinrichtungen des Drucks (7), der Temperatur (9) und des Abstands (8) und eine Kontroll- und Steuervorrichtung enthält, die Informationen von den Messeinrichtungen des Drucks (7), der Temperatur (9) und des Abstands (8) empfangen und die Infrarotstrahlungseinrichtungen (6) und das (10, 30) abhängig von den empfangenen Informationen steuern kann.

7. Trocknungsverfahren einer EUV-Fotomaske mittels der Trocknungsvorrichtung nach einem der vorhergehenden Ansprüche, das die folgenden Schritte enthält:

    - die EUV-Fotomaske (13) wird in einem dichten Behälter (2) unter Atmosphärendruck positioniert,
    - die EUV-Fotomaske (13) wird bis auf eine auf höchstens gleich 60°C festgelegte Temperatur erwärmt,
    - im dichten Behälter (2) wird ein Niederdruck aufgebaut, indem die in ihm enthaltenen Gase gepumpt werden,
    - der Behälter (2) wird während einer festgelegten Dauer auf Niederdruck und auf der festgelegten Temperatur gehalten,
    - die Erwärmung der EUV-Fotomaske (13) wird angehalten,
    - durch Injektion eines Schutzgases wird der Atmosphärendruck im Behälter (2) wiederhergestellt, und
    - es wird überprüft, dass die Temperatur der EUV-Fotomaske (13) etwa 30-35°C beträgt, ehe die EUV-Fotomaske (13) aus dem Behälter (2) entfernt wird.

8. Verfahren nach dem vorhergehenden Anspruch, wobei die Positionierung der EUV-Fotomaske mittels mindestens drei Ultraschall-Abstandssensoren (8) überprüft wird.

**Claims**

1. Device for drying an EUV photomask comprising:

    - a sealed chamber (2) able to receive at least one EUV photomask (13),
    - a pumping unit (3) to set up and maintain vacuum within said chamber (2),
    - a photomask support (12) placed within said chamber (2),
    - infrared radiation means (6) placed within said chamber (2),
    - a system (10) for injecting gas into said chamber (2),

in which device the infrared radiation means comprise a plurality of infrared radiation sources (6) distributed in a plane parallel to the plane of the surface of the EUV photomask (13) in such a way that the distance from the surface of the EUV photomask (13) to the IR radiation means is given by the relationship:

$$D = 1.5 \times d$$

wherein D is the distance between the plane containing the infrared radiation sources (6) and the surface of the EUV photomask (13) and d is the distance between the center points of two neighboring infrared radiation sources (6), the gas-injection system (10) comprising a plurality of gas injectors (30) distributed in a plane parallel to the plane of the EUV photomask (13) in such a way that the injectors (30) follow a 90° rotational invariance about the center point of the EUV photomask (13), the drying device comprising at least three infrared radiation sources (6) aligned so that two infrared radiation sources (6) are placed respectively on either side of the EUV photomask (13) and one infrared radiation source (6) at least is placed facing the center of the EUV photomask (13), the diameter of the gas-injection orifice, placed so as to be facing the center of the EUV photomask (13), being greater than the diameter of the other gas-injection orifices.

2. Drying device according to claim 1, wherein the infrared radiation sources (6) are placed so as to send infrared radiation perpendicularly to the active surface of the EUV photomask (13).

3. Drying device according to either of the above claims, comprising temperature-measuring means (9) provided with pyrometers, placed so as to measure the temperature on the edge of the EUV photomask (13).

4. Drying device according to one of the above claims, comprising a photomask support (12) comprising means for receiving and positioning the photomask, comprising a pierced frame (40) suspended inside said chamber (2).

5. Drying device according to one of the above claims, comprising ultrasonic distance sensors (8).

6. Drying device according to one of the above claims, comprising means for measuring pressure (7), temperature (9) and distance (8) and a control and command device capable of receiving information from the means for measuring pressure (7), temperature (9) and distance (8) and capable of making the infrared radiation means (6) and the gas-injection system (10, 30) operate as a function of the information received.

7. Method for drying an EUV photomask by means of a drying device according to one of the above claims, comprising the following steps:

- the EUV photomask (13) is positioned in a sealed chamber (2) at atmospheric pressure,
- the EUV photomask (13) is heated to a fixed temperature equal at most to 60°C,
- a low pressure is set up in the sealed chamber (2) by the pumping out of the gases that it contains,
- the chamber (2) is kept at low pressure and at the fixed temperature for a fixed duration,
- the heating of the EUV photomask (13) is stopped,
- atmospheric pressure is restored in the chamber (2) by injection of a neutral gas, and
- it is ascertained that the temperature of the EUV photomask (13) is about 30°-35°C before the EUV photomask (13) is extracted from the chamber (2).

8. Method according to the above claim, wherein the positioning of the EUV photomask is verified by means of at least three ultrasonic distance sensors (8).

Fig.1

Fig.3

Fig.4

Contours of Static Temperature (k)

3.58e+02
3.57e+02
3.57e+02
3.57e+02
3.57e+02
3.57e+02
3.57e+02
3.57e+02
3.57e+02
3.56e+02
3.56e+02
3.56e+02
3.56e+02
3.56e+02
3.56e+02
3.56e+02
3.55e+02
3.55e+02
3.55e+02
3.55e+02

Fig.5

Fig.6

Pathlines Colored by time (s)

5.00e+01
4.75e+01
4.50e+01
4.25e+01
4.00e+01
3.75e+01
3.50e+01
3.25e+01
3.00e+01
2.75e+01
2.50e+01
2.25e+01
2.00e+01
1.75e+01
1.50e+01
1.25e+01
1.00e+01
7.50e+02
5.00e+02
2.50e+02
0.00e+00

## Fig.7

## Fig.8

**EP 2 588 823 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2009112655 A